# EUROPEAN PATENT APPLICATION

(11) **EP 4 640 733 A1**
(43) Date of publication of application: **29.10.2025**
(21) Application number: 23907073.3
(22) Date of filing: 20.12.2023
(51) Int. Cl.: C08G 59/20, C08J 5/24, C09D 163/00, C09J 163/00, H01L 23/29, H01L 23/31

(54) **EPOXY RESIN, PRODUCTION METHOD FOR SAME, CURABLE RESIN COMPOSITION, AND CURED PRODUCT**

(30) Priority: 20.12.2022 JP 2022203478
(71) Applicant: Mitsubishi Chemical Corporation, Tokyo 100-8251 (JP)
(72) Inventor: SUGIYAMA, Daiki, Tokyo 100-8251 (JP); SAKAZAKI, Hiroaki, Tokyo 100-8251 (JP)
(74) Representative: TBK
(86) International application number: PCT/JP2023/045630
(87) International publication number: WO 2024/135713

(57) **Abstract**

An epoxy resin includes a compound X represented by the following Formula (1). In the epoxy resin, the content rate of an oligomer including the compound X is 0.01 to 19.0% by area in a case in which the total area of a detected peak is 100% by area in reverse phase HPLC measurement using a 280 nm UV detector. In Formula (1), a plurality of R may be the same as or different from each other, are hydrogen atoms or hydrocarbon groups, or may include a hetero atom, the plurality of R may be bound to each other to form a ring, or at least one of the plurality of R is a hydrocarbon group.

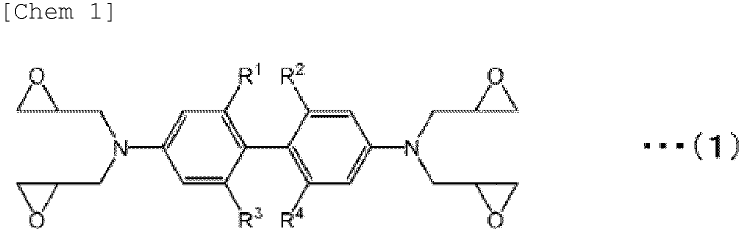

## Description

### TECHNICAL FIELD

The present invention relates to: an epoxy resin; a method of producing an epoxy resin; a curable resin composition including the epoxy resin; and a cured product of the curable resin composition. The present invention also relates to a paint, adhesive agent, prepreg, and semiconductor sealing agent including the curable resin composition, and a coating film, bonded body, fiber reinforced plastic, and electric and electronic material including the cured product.

### BACKGROUND ART

Epoxy resins have been excellent in electrical characteristics, adhesiveness, heat resistance, moldability, or the like, and have been therefore used mainly in many applications such as paint, civil engineering, electric, and sports fields. Especially, glycidyl amine type epoxy resins have been widely used because the glycidyl amine type epoxy resins have had low molecular weights and have been polyfunctional, and therefore, the heat resistance of the cured products of the glycidyl amine type epoxy resins has been favorable. The glycidyl amine type epoxy resins have been materials suitable particularly for semiconductor sealing materials, and matrix resins for carbon fiber reinforced plastics (CFRPs) utilizing favorable wettability with carbon fibers.

In recent years, instead of Si semiconductors, SiC semiconductors have been considered to be useful in the field of power semiconductors. The dielectric breakdown electric field intensity of SiC is around 10 times higher than that of Si. Therefore, SiC enables the thickness of a depletion layer to be decreased while securing a withstand voltage property even in the structure of a device such as a Schottky barrier diode or a MOSFET. As a result, SiC power devices can simultaneously achieve high withstand voltages, fast switching characteristics, and low-temperature resistance. Furthermore, the band gap of SiC is around three times wider than that of Si. Therefore, SiC enables the provision of power devices that can be operated even at high temperature. Therefore, cured products obtained by mixing epoxy resins, used as raw materials for semiconductor sealing materials, with curing agents, and curing the mixture are also required to be excellent in heat resistance at which the cured products are expected to be used under high-temperature environments. Moreover, demands for high heat resistance are high not only in such electric and electronic applications as described but also in various applications such as CFRPs. In particular, CFRPs are used as base materials for aircraft and vehicles, and therefore also require high elastic modulus. Epoxy resins or polyfunctional epoxy resins having rigid molecular frameworks are commonly used in order to enhance the glass transition points of cured products. However, even if a polyfunctional epoxy resin is used, an elastic modulus may be inhibited from being increased depending on the manner of blending. Thus, an epoxy resin enabling both a high glass transition point and a high elastic modulus to be achieved has been demanded.

Patent Literature 1 discloses a tetraglycidyl amine body of m-tolidine as an epoxy resin having a rigid and polyfunctional molecular structure. A liquid crystal alignment agent to which this compound is added enables formation of a liquid crystal alignment film having favorable storage stability, excellent transparency, and a favorable liquid crystal alignment property.

### PRIOR ART DOCUMENTS

### PATENT DOCUMENTS

Patent Literature 1: Japanese Patent Publication Laid-Open No. 2006-23595

### SUMMARY OF INVENTION

### TECHNICAL PROBLEM

In Patent Literature 1, a tetraglycidyl aminic body of m-tolidine is evaluated as an additive for a liquid crystal alignment agent. However, an epoxy resin is commonly mixed with another epoxy resin or a curing agent, and used in the case of producing a paint, an adhesive agent, a prepreg, a semiconductor sealing agent, or the like. There has been an apprehension that the tetraglycidyl amine body of m-tolidine contains a biphenyl framework, and therefore, a commonly used production method results in an increase in viscosity and the deterioration of miscibility.

The present invention was accomplished in view of the conventional technologies described above, and addresses a problem of providing an epoxy resin that is excellent in miscibility with another epoxy resin and a curing agent, and enables a cured product having favorable heat resistance and a favorable elastic modulus to be obtained. Moreover, the present invention addresses another problem of providing: a curable resin composition including the epoxy resin; and a cured product thereof.

### SOLUTION TO PROBLEM

As a result of intensive examination for solving the problems described above, the present inventors found that the problems described above can be solved by using an epoxy resin which includes a compound X having a diaminobiphenyl framework, and in which the content rate of an oligomer including the compound X is 0.01 to 19.0% by area in a case in which the total area of a detected peak is 100% by area in reverse phase HPLC measurement using a 280 nm UV detector. Thus, the present invention was accomplished.

In other words, the present invention has the following features.
[1] An epoxy resin including a compound X represented by the following Formula (1), wherein
   a content rate of an oligomer including the compound X is 0.01 to 19.0% by area in a case in which a total area of a detected peak is 100% by area in reverse phase HPLC measurement using a 280 nm UV detector 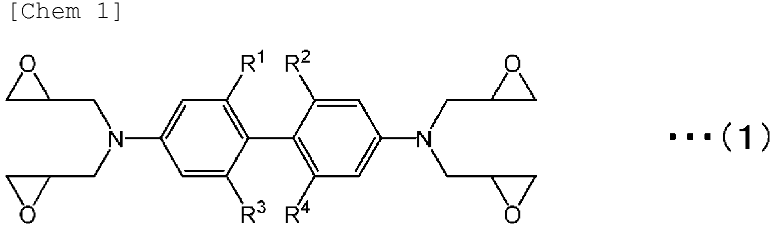 (in Formula (1), R¹ to R⁴ may be same as or different from each other, are hydrogen atoms or hydrocarbon groups, or may include a hetero atom; R¹ to R⁴ may be bound to each other to form a ring; or at least one of R¹ to R⁴ is a hydrocarbon group).
[2] The epoxy resin according to [1], wherein Formula (1) is the following Formula (2): 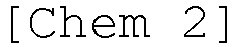 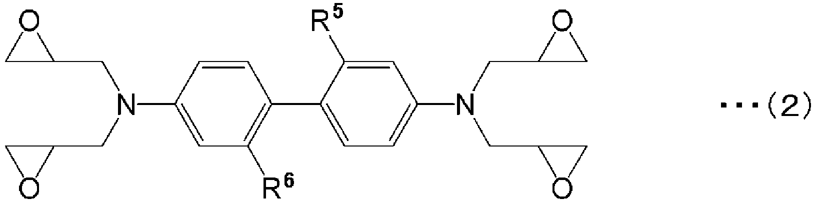 (in Formula (2), R⁵ and R⁶ may be same as or different from each other, are hydrocarbon groups, or may include a hetero atom; or R⁵ and R⁶ may be bound to each other to form a ring).
[3] The epoxy resin according to [2], wherein Formula (1) is the following Formula (3). 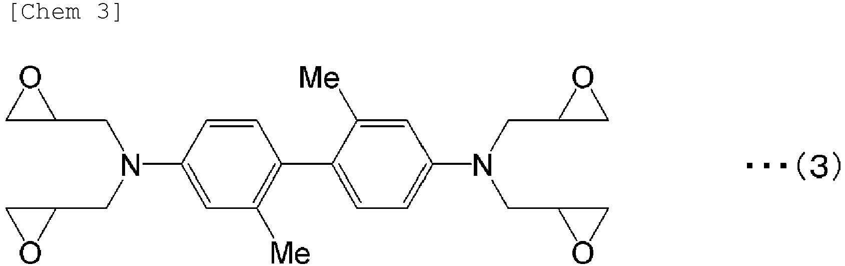
[4] The epoxy resin according to any one of [1] to [3], wherein the epoxy resin has a viscosity of 500 to 500,000 mPa·s at 50°C.
[5] The epoxy resin according to any one of [1] to [4], wherein the epoxy resin has an epoxy equivalent of 100 to 500 g/eq.
[6] The epoxy resin according to any one of [1] to [5], wherein an amount of an easily saponifiable halogen is 1 to 20,000 ppm by mass.
[7] A resin composition including: the epoxy resin according to any one of [1] to [6]; and a curing agent.
[8] A paint including the resin composition according to [7].
[9] An adhesive agent including the resin composition according to [7].
[10] A prepreg including the resin composition according to [7].
[11] A semiconductor sealing material including the resin composition according to [7].
[12] A cured product including the resin composition according to [7].
[13] The cured product according to [12], wherein the cured product has a bending elastic modulus of 3.5 GPa or more.
[14] A coating film including the cured product according to [12].
[15] A bonded body including the cured product according to [12].
[16] A fiber reinforced plastic including the cured product according to [12].
[17] A semiconductor sealing material including the cured product according to [12].
[18] An electric and electronic material including the cured product according to [12].
[19] A method of producing an epoxy resin, wherein
   the method includes a step of performing a reaction between an epihalohydrin and an amine compound represented by the following Formula (4), and the epoxy resin is the epoxy resin according to any one of [1] to [6] 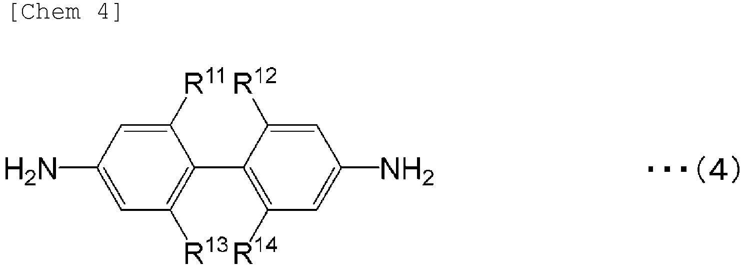 (in Formula (4), R¹¹ to R¹⁴ are synonymous with R¹ to R⁴ in Formula (1), respectively).
[20] The method of producing an epoxy resin according to [19], wherein an amount of the epihalohydrin used is 8.1 equivalents or more with respect to that of the amine compound.
[21] The method of producing an epoxy resin according to [19] or [20], wherein in the step of performing the reaction between the amine compound and the epihalohydrin, the reaction is performed without using a catalyst, and reaction time is more than 180 minutes.

### ADVANTAGEOUS EFFECTS OF INVENTION

In accordance with the present invention, an epoxy resin that is excellent in miscibility with another epoxy resin and a curing agent, and has favorable heat resistance and a favorable elastic modulus can be provided. Moreover, in accordance with the present invention, a curable resin composition including the epoxy resin, and a cured product thereof can be provided.

### DESCRIPTION OF EMBODIMENTS

Embodiments of the present invention are described in detail below. However, the present invention is not limited to the following description, but optional modifications can be made without departing from the gist of the present invention. In the present invention, an expression of "x to y", in which x and y are numerical values or physical property values, is used to include x and y. Herein, when the lower and upper limit values of a numerical range are separately described, the numerical range may include a combination of an optional lower limit value and an optional upper limit value.

Herein, "mass" and "weight" are synonymous with each other, and "weight" may be called "mass".

### [Epoxy Resin]

An epoxy resin which is a first embodiment of the present invention (hereinafter may be simply referred to as "this epoxy resin") is an epoxy resin including a compound X represented by the following Formula (1). The epoxy resin according to the present embodiment is an epoxy resin including a compound X having a diaminobiphenyl framework. In the epoxy resin, the content rate of an oligomer including the compound X is 0.01 to 19.0% by area in a case in which the total area of a detected peak is 100% by area in reverse phase HPLC measurement using a 280 nm UV detector. Herein, the epoxy resin is a concept including an epoxy compound, and is regarded as a material (composition) including a plurality of substances, that is, a material (composition) including at least an epoxy compound X and an oligomer including the epoxy compound X.

A cured product obtained by curing the following compound X by using a curing agent or the like exhibits favorable heat resistance and a favorable elastic modulus.

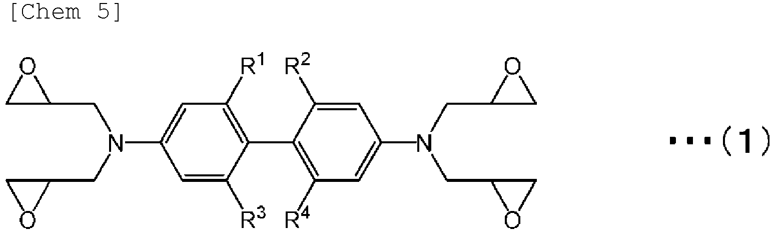

In Formula (1) above, R¹ to R⁴ may be the same as or different from each other, are hydrogen atoms or hydrocarbon groups, or may include a hetero atom, R¹ to R⁴ may be bound to each other to form a ring, or at least one of R¹ to R⁴ is a hydrocarbon group.

Examples of the hydrocarbon group include a methyl group, an ethyl group, a propyl group, an isopropyl group, a butyl group, a tert-butyl group, a phenyl group, and a trifluoromethyl group, and include structures in which these hydrocarbon groups are bound to each other to form rings in a case in which R¹ to R⁴ are bound to each other to form a ring. A methyl group, an isopropyl group, a phenyl group, or a trifluoromethyl group is preferred from the viewpoint of availability. Of these, a methyl group is particularly preferred from the viewpoint of enabling a thermal decomposition temperature to be enhanced.

The hetero atom is not particularly limited, and examples thereof include nitrogen, oxygen, sulfur, phosphorus, silicon, fluorine, chlorine, bromine, and iodine.

The number of hydrocarbon groups in R¹ to R⁴ is not particularly limited, and is preferably one or more from the viewpoint of enabling a dihedral angle between benzene rings to be shifted to divide a conjugated system, and to allow reactivity in production to be favorable. The number hydrocarbon groups in R¹ to R⁴ is preferably two or four, and particularly preferably two from the viewpoint of enabling a raw material with stable quality to be obtained to improve production stability. Specifically, for example, an aspect in which all of R¹ to R⁴ are hydrocarbon groups, or an aspect in which R² and R³ are hydrocarbon groups, and R¹ and R⁴ are hydrogen atoms is preferred, and an aspect in which R² and R³ are hydrocarbon groups, and R¹ and R⁴ are hydrogen atoms is particularly preferred.

The structure represented by Formula (1) above is preferably a structure represented by the following Formula (2) from the viewpoint of enabling reactivity in production to be favorable, and from the viewpoint of enabling a thermal decomposition temperature to be enhanced. It is a compound. This is the aspect in which R² and R³ are hydrocarbon groups, and R¹ and R⁴ are hydrogen atoms, described above.

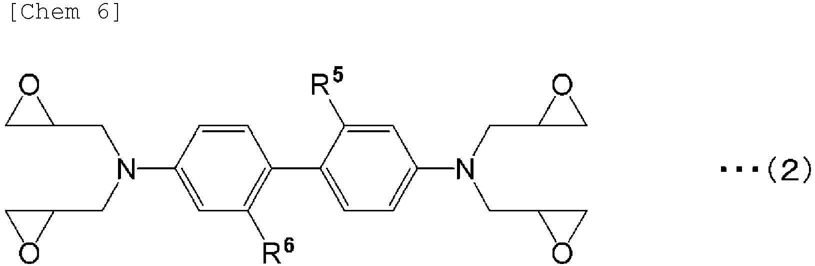

In Formula (2), R⁵ and R⁶ may be the same as or different from each other, are hydrocarbon groups, or may include a hetero atom, or R⁵ and R⁶ may be bound to each other to form a ring. The specific aspects of the hydrocarbon group and hetero atom described above in R¹ to R⁴ can be similarly applied to a hydrocarbon group and a hetero atom in R⁵ and R⁶, respectively.

The structure represented by Formula (1) is more preferably a structure represented by the following formula (3) from the viewpoint of enabling reactivity in production to be favorable, and from the viewpoint of enabling a thermal decomposition temperature to be enhanced.

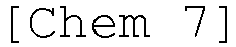

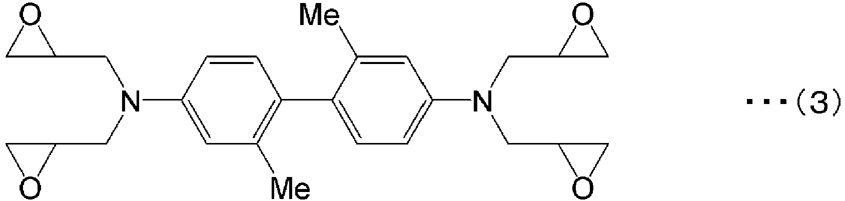

In Formula (1), Me represents a methyl group.

### [Physical Properties and Characteristics of This Epoxy Resin]

The lower limit value of the epoxy equivalent of this epoxy resin is preferably 50 g/eq or more, more preferably 70 g/eq or more, and particularly preferably 100 g/eq or more. The epoxy equivalent is allowed to be not less than the lower limit value described above, whereby appropriate viscosity can be secured, and, as a result, miscibility with another epoxy resin and a curing agent becomes favorable.

On the other hand, the upper limit value of the epoxy equivalent of this epoxy resin is preferably 500 g/eq or less, more preferably 300 g/eq or less, still more preferably 200 g/eq or less, particularly preferably 150 g/eq or less, and especially particularly preferably 125 g/eq or less. The epoxy equivalent is allowed to be not more than the upper limit value described above, whereby viscosity at high temperature can be decreased to allow handleability to be favorable.

The upper limit value of the viscosity of this epoxy resin at 50°C is preferably 500,000 mPa·s or less, more preferably 200,000 mPa·s or less, still more preferably 130,000 mPa·s or less, and particularly preferably 120,000 mPa·s or less. In a case in which the viscosity at 50°C is not more than the upper limit value described above, the homogeneous mixture can be facilitated to produce a cured product with homogeneous quality.

On the other hand, the lower limit value of the viscosity of this epoxy resin at 50°C is preferably 100 mPa·s or more, more preferably 500 mPa·s or more, still more preferably 1,000 mPa·s or more, and particularly preferably 10,000 mPa·s or more. In a case in which the viscosity at 50°C is not less than the lower limit value described above, the mixture can be performed by shearing, and therefore, the homogeneous mixture is facilitated.

The viscosity of an epoxy resin at 50°C can be measured by, for example, methods described in Examples described later.

The upper limit value of the viscosity of this epoxy resin at 150°C is preferably 100 mPa·s or less, more preferably 80 mPa·s or less, still more preferably 70 mPa·s or less, and particularly preferably 60 mPa·s or less. In a case in which the viscosity at 150°C is not more than the upper limit value described above, the homogeneous mixture can be facilitated to produce a cured product with homogeneous quality.

On the other hand, the lower limit value of the viscosity of this epoxy resin at 150°C is preferably 1 mPa·s or more, more preferably 10 mPa·s or more, and particularly preferably 20 mPa·s or more. In a case in which the viscosity at 150°C is not less than the lower limit value described above, the mixture can be performed by shearing, and therefore, the homogeneous mixture is facilitated.

The viscosity of an epoxy resin at 150°C can be measured by, for example, the methods described in Examples described later.

The epoxy equivalent of this epoxy resin, the viscosity of the epoxy resin at 50°C, and the viscosity of the epoxy resin at 150°C are measured by methods described in sections in Examples described later.

This epoxy resin may include an easily saponifiable halogen. Specifically, typical examples of the easily saponifiable halogen include chlorine and bromine. The amount of an easily saponifiable halogen in an epoxy resin can be measured according to JIS K7243-2.

The upper limit value of the amount of the easily saponifiable halogen in this epoxy resin is preferably 20,000 ppm by mass or less, more preferably 11,000 ppm by mass or less, still more preferably 9,000 ppm by mass or less, still more preferably 3,000 ppm by mass or less, still more preferably 1,000 ppm by mass or less, still more preferable 500 ppm by mass or less, and particularly preferably 200 ppm by mass or less. In a case in which the amount of the easily saponifiable halogen is not more than the lower limit value described above, the corrosion of a metal portion used in the wiring line of a product can be prevented from corroding in use as an electronic material.

On the other hand, the lower limit value of the amount of the easily saponifiable halogen in this epoxy resin is preferably 1 ppm by mass or more, more preferably 10 ppm by mass or more, and particularly preferably 50 ppm by mass or more. In a case in which the amount of the easily saponifiable halogen is not less than the lower limit value described above, production is possible in an economical process using an epihalohydrin.

The upper limit value of the total halogen amount in this epoxy resin is preferably 50,000 ppm by mass or less, more preferably 20,000 ppm by mass or less, still more preferably 15,000 ppm by mass or less, still more preferably 10,000 ppm by mass or less, and particularly preferably 7,000 ppm by mass or less. In a case in which the total halogen amount is not more than the lower limit value described above, a metal portion used in the wiring line of a product can be prevented from corroding in used as an electronic material.

On the other hand, the lower limit value of the total halogen amount in this epoxy resin is preferably 1 ppm by mass or more, more preferably 10 ppm by mass or more, still more preferably 100 ppm by mass or more, and particularly preferably 500 ppm by mass or more. In a case in which the total halogen amount is not less than the lower limit value described above, production is possible in an economical process using an epihalohydrin.

The total halogen amount in the epoxy resin can be measured according to JIS K7243-3.

Each of the preferred ranges of the amount of the easily saponifiable halogen and the total halogen amount may be adopted as the range of the amount of each single halogen (for example, in the case of chlorine, each of the amount of easily saponifiable chlorine and the total amount of chlorine).

The lower limit value of the content rate of an oligomer including a compound X in a case in which the total area of a detected peak is 100% by area in reverse phase HPLC measurement using a 280 nm UV detector is preferably 0.01% by area or more, more preferably 0.1% by area or more, still more preferably 0.5% by area or more, and still more preferably 1.0% by area or more. An infinite increase in reaction time is required for removing the oligomer having a structural unit derived from the compound X. Thus, the removal of the oligomer is unpractical. In a case in which the content rate described above is not less than the lower limit value described above, a reaction can be carried out for practical production time, and process stability can be improved.

The upper limit value of the content rate of the oligomer having the structural unit derived from the compound X is preferably 19.0% by area or less, more preferably 17.0% by area or less, still more preferably 16.0% by area or less, and particularly preferably 10.0% by area or less. In a case in which the content rate described above is not more than the upper limit described above, miscibility with another epoxy resin and a curing agent is favorable, viscosity at ordinary temperature is in a range in which handling is easy, and handleability is improved.

Herein, the oligomer including the compound X is an oligomer that can be produced as a by-product in production of the compound X. For example, the oligomer is an oligomer generated by adding an epoxy group in the compound X and an active hydrogen-containing compound, or an oligomer generated by anionic polymerization with the compound X in itself as a tertiary amine catalyst. Specifically, the oligomer including the compound X in the present specification is a compound in a compound group of which the retention time is longer than the retention time of a compound X in reverse phase HPLC measurement.

The lower limit value of the content rate of the compound X in this epoxy resin is not particularly limited, and is preferably 60% by area or more, mor preferably 70% by area or more, still more preferably 80% by area or more, and particularly preferably 85% by area or more. In a case in which the content rate is not less than the lower limit described above, the content of an epoxy group per unit weight is enhanced, and, as a result, a crosslink density in the formation of an epoxy resin cured product is enhanced to improve heat resistance.

The upper limit value of the content rate of the compound X in this epoxy resin is not particularly limited, and may be 99% by area or less, may be 95% by area or less, or may be 90% by area or less. The content rate of the compound X in this epoxy resin is preferably 100% by area. However, the content rate may be the upper limit value described above because it is unpractical to remove an oligomer including the compound X, as described above.

Examples of low molecular weight components excluding the compound X include compounds in which at least one glycidyl group in the compound X is substituted with the following groups or atom: an α-glycol group, a 1,2-halohydrin group, a 1,3-halohydrin group, a group in which an epihalohydrin is added to the α-OH of an α-glycol group, a group in which an epihalohydrin is added to the β-OH of an α-glycol group, a group in which an epihalohydrin is added to the β-OH of a 1,2-halohydrin group, a group in which an epihalohydrin is added to the α-OH of a 1,3-halohydrin group, a group in which α-addition of the alcohol of a reaction solvent to a glycidyl group occurs, and a hydrogen atom. These compounds are inevitably produced as side reactions when a glycidyl compound is produced using an epihalohydrin.

The lower limit value of a low molecular weight component excluding the compound X in this epoxy resin is not particularly limited, and may be 0.01% by area or more, may be 0.1% by area or more, may be 1% by area or more, or may be 3% by area or more. The content rate of a low molecular weight component excluding the compound X and epoxy compound X in this epoxy resin is preferably 0% by area, or may be the lower limit value described above because it is unpractical to remove a low molecular weight component, as described above.

The upper limit value of the low molecular weight component excluding the compound X in this epoxy resin is not particularly limited, and is preferably 30% by area or less, mor preferably 20% by area or less, and particularly preferably 15% by area or less. In a case in which the content rate is not more than the upper limit described above, the content of an epoxy group per unit weight is enhanced, and, as a result, a crosslink density in the formation of an epoxy resin cured product is enhanced to improve heat resistance.

### [Method of Producing This Epoxy Resin]

A method of producing an epoxy resin of the present embodiment is not particularly limited, and may be, for example, a production method including a step of reacting an amine compound represented by the following Formula (4) with an epihalohydrin. Specific examples thereof include a method of subjecting these compounds to an addition reaction in the absence of a catalyst and then to a ring closure reaction in the presence of an alkali metal hydroxide.

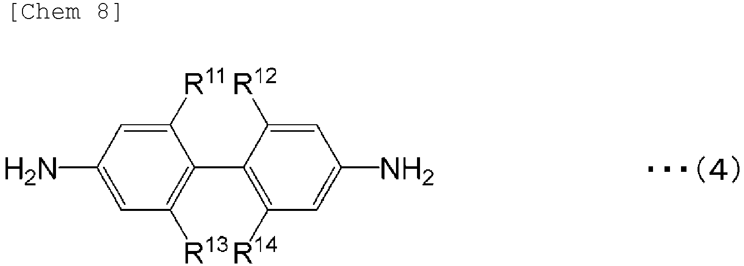

In Formula (4), R¹¹ to R¹⁴ are synonymous with R¹ to R⁴ in Formula (1), respectively, and the conditions thereof can also be similarly applied.

The addition and ring closure reactions of the amine compound and the epihalohydrin include four steps A to D in total. The step A is a process of allowing the addition reaction of an amino group and an epihalohydrin to proceed while increasing the temperature from room temperature to a predetermined reaction temperature. The step B is a process of generally completing the addition reaction by performing maturation at the predetermined reaction temperature. The step C is a process of allowing the ring closure reaction of a 1,2-halohydrin body to proceed while separately charging an alkali metal hydroxide at the predetermined reaction temperature. The step D is a process of generally completing the ring closure reaction by performing maturing at the predetermined reaction temperature.

As the epihalohydrin, epichlorohydrin, epibromohydrin, or the like is commonly used, and, in the present embodiment, epichlorohydrin is preferred from the viewpoint of economic efficiency.

The amount of the epihalohydrin used is preferably an amount corresponding to typically 4.1 equivalents or more and 40.0 equivalents or less, particularly 6.2 equivalents or more and 30.0 equivalents or less, or especially 8.1 equivalents or more and 20.0 equivalents or less per equivalent of an amine compound used as a raw material (with respect to 1 equivalent of an amine compound). A case in which the amount of the epihalohydrin is not less than the lower limit described above is preferred because a reaction for increasing a molecular weight is easily controlled, the viscosity of an obtained epoxy resin can be decreased, and a mixture of the epoxy resin is facilitated in blending. On the other hand, a case in which the amount of the epihalohydrin is not more than the upper limit described above is preferred because production efficiency tends to be improved. Herein, "use" may be called "addition" which is one aspect thereof.

An alkali metal hydroxide in an amount corresponding to typically 0.5 to 2.0 equivalents, preferably 0.9 to 1.6 equivalents, per equivalent of active hydrogen in the amine compound as a raw material, as the amount of the alkali metal hydroxide used in the step C, is added in a solid or aqueous solution, and subjected to reaction. Here, active hydrogen means a hydrogen atom bound to the nitrogen atom of an amino group. For example, the amine compound in Formula (3) includes four active hydrogen atoms. A case in which the amount of the alkali metal hydroxide used is not less than the lower limit described above is preferred because an unreacted hydroxyl group and a generated epoxy resin are inhibited from reacting with each other to facilitate the control of a reaction for increasing a molecular weight. A case in which the amount of the alkali metal hydroxide used is not more than the upper limit described above is preferred because impurities are inhibited from being generated by side reaction. Typical examples of the alkali metal hydroxide used here include sodium hydroxide and potassium hydroxide.

This reaction can be carried out under ordinary pressure or reduced pressure, and the temperature of the reaction is preferably 20 to 150°C, and more preferably 40 to 100°C. A case in which the reaction temperature is not less than the lower limit described above is preferred because the reaction is allowed to proceed easily, and the reaction is easily controlled. A case in which the reaction temperature is not more than the upper limit described above in the range described above is preferred because side reaction is inhibited from proceeding, and in particular, an epoxy compound in which the amount of an oligomer component is easily reduced, and which has an easily handleable viscosity is obtained.

The steps A to D which are steps of performing a reaction between an amine compound and epichlorohydrin are consecutively carried out, and the lower limit value of the total time required in the steps is preferably more than 180 minutes, more preferably more than 200 minutes, still more preferably more than 240 minutes, and particularly preferably more than 300 minutes in a case in which a catalyst described later is not used (in the case of performing the reaction without using the catalyst). The reaction for the time that is not less than the lower limit value described above enables a reaction in which the addition reaction and ring closure reaction are separated from each other, and enables the obtainment of an epoxy resin in which the amount of an oligomer component is reduced, and which has a low viscosity. In a case in which a catalyst described later is used (in a case in which the reaction is performed using the catalyst), the lower limit value of the total time required in the steps A to D is preferably set at a time that is 50% of each lower limit value described above because the amount of the oligomer component can be reduced even for time shorter than the lower limit value described above.

On the other hand, the upper limit value is preferably 1200 minutes or less, more preferably 600 minutes or less, and particularly preferably 500 minutes or less. The case of being not more than the upper limit value described above is preferred because production efficiency tends to be improved.

In this reaction, it is acceptable to use a catalyst such as: a quaternary ammonium salt such as tetramethylammonium chloride or tetraethylammonium bromide; a tertiary amine such as benzyldimethylamine or 2,4,6-tris(dimethylaminomethyl)phenol; an imidazole such as 2-ethyl-4-methylimidazole or 2-phenylimidazole; a phosphonium salt such as ethyltriphenylphosphoniumiodide; or a phosphine such as triphenylphosphine. The catalyst is not limited only to the compounds described above. The catalyst is not limited at all as long as the catalyst is a compound that enables an increase in the rate of reaction between an epihalohydrin and an amine compound.

Purity may be increased to perform purification by a technique in which the ring closure reaction of a residual 1,2-halohydrin body is promoted by reacting the epoxy resin produced as described above with an alkali again, a technique by recrystallization, or a technique by distillation. These techniques may be used in combination. The purification by the reaction with an alkali is preferred from the viewpoint of economic efficiency.

In the reaction step or purification step for producing this epoxy resin, a solvent may be used. Any solvent is acceptable as the solvent as long as a raw material is dissolved in the solvent. An organic solvent is commonly used, and water may also be used.

Examples of such organic solvents include alcohol-based solvents, aromatic solvents, ketone-based solvents, amide-based solvents, and glycol ether-based solvents.

Specific examples of the alcohol-based solvents include methanol, ethanol, and isopropanol.

Specific examples of the aromatic solvents include benzene, toluene, and xylene.

Specific examples of the ketone-based solvents include acetone, methyl ethyl ketone, methyl isobutyl ketone, 2-heptanone, 4-heptanone, 2-octanone, cyclopentanone, cyclohexanone, and acetylacetone.

Specific examples of the amide-based solvents include formamide, N-methylformamide, N,N-dimethylformamide, acetamide, N-methylacetamide, N,N-dimethylacetamide, 2-pyrrolidone, and N-methyl-2-pyrrolidone.

Specific examples of the glycol ether-based solvents include ethylene glycol monomethyl ether, ethylene glycol monoethyl ether, ethylene glycol mono-n-butyl ether, ethylene glycol dimethyl ether, ethylene glycol monoethyl ether acetate, diethylene glycol monomethyl ether, diethylene glycol monoethyl ether, diethylene glycol mono-n-butyl ether, diethylene glycol dimethyl ether, diethylene glycol monoethyl ether acetate, propylene glycol monomethyl ether, propylene glycol mono-n-butyl ether, and propylene glycol monomethyl ether acetate.

The solvents mentioned above may be used singly, or in optional combination of two or more kinds thereof at an optional ratio.

### [Resin Composition]

A resin composition which is another embodiment of the present invention (hereinafter also referred to as "curable resin composition") includes at least this epoxy resin described above and a curing agent. Moreover, the curable resin composition can be optionally blended as appropriate with another epoxy resin (hereinafter may be simply referred to as "other epoxy resin") other than this epoxy resin, a curing accelerator, an inorganic filler, a coupling agent, or the like.

### [Curing Agents]

In the present embodiment, the curing agent refers to a substance contributing to a crosslinking reaction and/or a chain-lengthening reaction between epoxy groups in an epoxy resin. In the present disclosure, a substance that is commonly called a "curing accelerator" can be regarded as the curing agent as long as the substance contributes to a crosslinking reaction and/or chain-lengthening reaction between epoxy groups in an epoxy resin.

In the curable resin composition of the present embodiment, the content of the curing agent is preferably 0.1 to 1,000 parts by weight with respect to 100 parts by weight of a total epoxy resin component as a solid content. Moreover, the content is more preferably 500 parts by weight or less, still more preferably 300 parts by weight or less. In the present disclosure, "solid content" means a component excluding a solvent, and encompasses not only a solid epoxy resin but also a semi-solid or viscous liquid substance. Moreover, the "total epoxy resin component" is equivalent to the amount of an epoxy resin included in the curable resin composition, and is equivalent to the total of an epoxy resin in this epoxy resin and another epoxy resin when the curable resin composition includes this epoxy resin and the other epoxy resin.

The curing agent is not particularly limited, and all the curing agents that are commonly known as epoxy resin curing agents can be used. Examples thereof include: phenolic curing agents; amine-based curing agents such as aliphatic amines, polyether amines, alicyclic amines, and aromatic amines; acid anhydride-based curing agents; amide-based curing agents, tertiary amines, and imidazoles.

Of these, the curing agent preferably encompasses a phenolic curing agent or an aromatic amine-based curing agent because the curable resin composition of the present embodiment can have excellent heat resistance, stress resistance, moisture absorption resistance, flame resistance, and the like. The curing agent preferably encompasses an acid anhydride-based curing agent or an amide-based curing agent from the viewpoint of heat resistance and the like. It is also preferable to use an imidazole from the viewpoint of allowing a curing reaction to sufficiently proceed to improve heat resistance.

The curing agent may be used singly, or in combination of two or more kinds thereof. In the case of using two or more curing agents together, the curing agents may be mixed in advance to prepare and then use a mixed curing agent, or each component of the curing agents may be separately added and simultaneously mixed when each component of the curable resin composition is mixed.

### <Phenolic Curing Agents>

Specific examples of the phenolic curing agents include various phenol resins such as: various polyphenols such as bisphenol A, bisphenol F, bisphenol S, bisphenol AD, hydroquinone, resorcin, methylresorcin, biphenol, tetramethylbiphenol, dihydroxynaphthalene, dihydroxydiphenyl ether, thiodiphenol, phenol novolac resin, cresol novolac resin, phenol aralkyl resin, biphenyl aralkyl resin, naphthol aralkyl resin, terpene phenol resin, dicyclopentadiene phenol resin, bisphenol A novolac resin, trisphenol methane type resin, naphthol novolac resin, brominated bisphenol A, and brominated phenol novolac resin; polyphenol resins obtained by a condensation reaction of various phenols with various aldehydes such as benzaldehyde, hydroxybenzaldehyde, crotonaldehyde, and glyoxal; polyphenol resins obtained by a condensation reaction of xylene resin with phenols; cocondensated resins of heavy oils or pitches, phenols, and formaldehydes; phenol/benzaldehyde/xylylene dimethoxide polycondensates; phenol/benzaldehyde/xylylene dihalide polycondensates; phenol/benzaldehyde/4,4'-dimethoxide biphenyl polycondensates: and phenol/benzaldehyde/4,4'-dihalide biphenyl polycondensates.

These phenolic curing agents may be used singly, or in optional combination of two or more kinds thereof at an optional blending ratio.

The amount of the blended phenolic curing agent is preferably 0.1 to 1,000 parts by weight, more preferably 500 parts by weight or less, still more preferably 300 parts by weight or less, and particularly preferably 100 parts by weight or less with respect to 100 parts by weight of the total epoxy resin component in the curable resin composition.

### <Amine-Based Curing Agents>

Examples of the amine-based curing agents (excluding tertiary amines) include aliphatic amines, polyether amines, alicyclic amines, and aromatic amines.

Examples of the aliphatic amines include ethylenediamine, 1,3-diaminopropane, 1,4-diaminopropane, hexamethylenediamine, 2,5-dimethylhexamethylenediamine, trimethylhexamethylenediamine, diethylenetriamine, iminobispropylamine, bis(hexamethylene)triamine, triethylenetetramine, tetraethylenepentamine, pentaethylenehexamine, N-hydroxyethylethylenediamine, or tetra(hydroxyethyl)ethylenediamine.

Examples of the polyether amines include triethyleneglycoldiamine, tetraethyleneglycoldiamine, diethyleneglycol bis(propylamine), polyoxypropylenediamine, and polyoxypropylene triamine.

Examples of the alicyclic amines include isophoronediamine, menthenediamine, N-aminoethylpiperazine, bis(4-amino-3-methyldicyclohexyl)methane, bis(aminomethyl)cyclohexane, 3,9-bis(3-aminopropyl)-2,4,8,10-tetraoxaspiro(5,5)undecane, and norbornenediamine.

Examples of the aromatic amines include tetrachloro-p-xylenediamine, m-xylenediamine, p-xylenediamine, m-phenylenediamine, o-phenylenediamine, p-phenylenediamine, 2,4-diaminoanisole, 2,4-toluenediamine, 2,4-diaminodiphenylmethane, 4,4'-diaminodiphenylmethane, 4,4'-diamino-1,2-diphenylethane, 2,4-diaminodiphenylsulphone, 4,4'-diaminodiphenylsulphone, m-aminophenol, m-aminobenzylamine, benzyldimethylamine, 2-(dimethylaminomethyl)phenol, triethanolamine, methylbenzylamine, α-(m-aminophenyl)ethylamine, α-(p-aminophenyl)ethylamine, diaminodiethyl dimethyl diphenylmethane, α,α'-bis(4-aminophenyl)-p-diisopropylbenzene, and m-tolidine.

The amine-based curing agents may be used singly, or in optional combination of two or more kinds thereof at an optional blending ratio.

Such an amine-based curing agent is preferably used so that the equivalent ratio of a functional group in the curing agent to an epoxy group in the total epoxy resin component included in the curable resin composition is in a range of 0.8 to 1.5. A case in which the ratio is in the range is preferred because an unreacted epoxy group and the functional group of the curing agent are inhibited from remaining.

Examples of the tertiary amines include 1,8-diazabicyclo(5,4,0)undecene-7, triethylenediamine, benzyldimethylamine, triethanolamine, dimethylaminoethanol, and tris(dimethylaminomethyl)phenol.

The tertiary amines may be used singly, or in optional combination of two or more kinds thereof at an optional blending ratio.

Such a tertiary amine is preferably used so that the equivalent ratio of a functional group in the curing agent to an epoxy group in the total epoxy resin component included in the curable resin composition is in a range of 0.8 to 1.5. A case in which the ratio is in the range is preferred because an unreacted epoxy group and the functional group of the curing agent are inhibited from remaining.

### <Acid Anhydride-Based Curing Agents>

Examples of the acid anhydride-based curing agents include acid anhydrides, and modified products of acid anhydrides.

Examples of the acid anhydrides include phthalic anhydrides, trimellitic anhydrides, pyromellitic anhydrides, benzophenonetetracarboxylic anhydrides, dodecenylsuccinic anhydrides, polyadipic anhydrides, polyazelaic polyanhydrides, polysebacic anhydrides, poly(ethyloctadecanedioic) anhydrides, poly(phenylhexadecanedioic)anhydrides, tetrahydrophthalic anhydrides, methyltetrahydrophthalic anhydrides, methylhexahydrophthalic anhydrides, hexahydrophthalic anhydrides, methylhimic anhydrides, trialkyltetrahydrophthalic anhydrides, methylcyclohexenedicarboxylic anhydrides, methylcyclohexenetetracarboxylic anhydrides, ethyleneglycolbistrimellitate dianhydrides, HET anhydrides, nadic anhydrides, methylnadic anhydrides, 5-(2,5-dioxotetrahydro-3-furanyl)-3-methyl-3-cyclohexane-1,2-dicarboxylic anhydrides, 3,4-dicarboxy-1,2,3,4-tetrahydro-1-naphthalenesuccinic dianhydrides, and 1-methyl-dicarboxy-1,2,3,4-tetrahydro-1-naphthalenesuccinic dianhydrides.

Examples of the modified products of acid anhydrides include products obtained by modifying the above-described acid anhydrides with glycols. Examples of the glycols that can be used in the modification include: alkylene glycols such as ethylene glycol, propylene glycol, and neopentyl glycol; and polyether glycols such as polyethylene glycol, polypropylene glycol, and polytetramethylene ether glycol. Furthermore, copolymerized polyether glycols of two or more glycols and/or polyether glycols of the glycols can be used.

In the modified product of an acid anhydride, the modification with 0.4 mol or less of a glycol with respect to 1 mol of the acid anhydride is preferred. In a case in which a modification amount is not more than the upper limit value described above, an excessive increase in the viscosity of an epoxy resin composition tends to be prevented to achieve favorable workability, and the rate of curing reaction with an epoxy resin also tends to be favorable.

The acid anhydride-based curing agents may be used singly, or in optional combination of two or more kinds thereof in optional blending amounts.

Such an acid anhydride-based curing agent is preferably used so that the equivalent ratio of a functional group in the curing agent to an epoxy group in the total epoxy resin component in the curable resin composition is in a range of 0.8 to 1.5. A case in which the ratio is in the range is preferred because an unreacted epoxy group and the functional group of the curing agent are inhibited from remaining.

### <Amide-Based Curing Agents>

Examples of the amide-based curing agents include dicyandiamide or derivatives thereof, and polyamide resins. The amide-based curing agents may be used singly, or may be mixed and used in optional combination of two or more kinds thereof at an optional ratio. Such an amide-based curing agent is preferably used so that the amide-based curing agent is 0.1 to 20% by weight with respect to the total of the total epoxy resin component and the amide-based curing agent in the curable resin composition.

### <Imidazoles>

Examples of the imidazoles include 2-phenylimidazole, 2-ethyl-4(5)-methylimidazole, 2-phenyl-4-methylimidazole, 1-benzyl-2-methylimidazole, 1-benzyl-2-phenylimidazole, 1-cyanoethyl-2-undecylimidazole, 1-cyano-2-phenylimidazole, 1-cyanoethyl-2-undecylimidazoletrimellitate, 1-cyanoethyl-2-phenylimidazoliumtrimellitate, 2,4-diamino-6-[2'-methylimidazolyl-(1')]-ethyl-s-triazine, 2,4-diamino-6-[2'-ethyl-4'-methylimidazolyl-(1')]-ethyl-s-triazine, adducts of 2,4-diamino-6-[2'-methylimidazolyl-(1')]-ethyl-s-triazine isocyanuric acid, adducts of 2-phenylimidazole isocyanuric acid, 2-phenyl-4,5-dihydroxymethylimidazole, 2-phenyl-4-methyl-5-hydroxymethylimidazole, and adducts of epoxy resins and the imidazoles described above. The imidazoles have catalytic abilities, and therefore, can also be commonly classified as curing accelerators. However, the imidazoles are classified as curing agents in the present disclosure.

The imidazoles may be mixed and used singly, or in optional combination of two or more kinds thereof at an optional ratio. Such an imidazole is preferably used so that the imidazole is 0.1 to 20% by weight with respect to the total of a total epoxy resin component and the imidazole in the curable resin composition.

### <Other Curing Agents>

In the curable resin composition of the present embodiment, other curing agents except the curing agents can be used. The other curing agents that can be used in the curable resin composition of the present embodiment is not particularly limited, and all the curing agents that are commonly known as curing agents for epoxy resins can be used as the other curing agents. The other curing agents may be used singly, or in combination of two or more kinds thereof.

### [Other Epoxy Resins]

The curable resin composition of the present embodiment can include still another epoxy resin except this epoxy resin. The inclusion of the other epoxy resin enables improvement in the heat resistance, stress resistance, moisture absorption resistance, toughness, flame resistance, or the like of the curable resin composition of the present embodiment.

All the epoxy resins other than this epoxy resin correspond to the other epoxy resin that can be used in the curable resin composition of the present embodiment. Specific examples thereof include bisphenol A type epoxy resins, trisphenol methane type epoxy resins, anthracene type epoxy resins, phenol-modified xylene resin type epoxy resins, bisphenol cyclododecyl type epoxy resins, bisphenol diisopropylidene resorcin type epoxy resins, bisphenol F type epoxy resins, bisphenol AD type epoxy resins, hydroquinone type epoxy resins, methylhydroquinone type epoxy resins, dibutylhydroquinone type epoxy resins, resorcin type epoxy resins, methylresorcin type epoxy resins, biphenol type epoxy resins, tetramethylbiphenol type epoxy resins, tetramethyl bisphenol F type epoxy resins, dihydroxydiphenyl ether type epoxy resins, epoxy resins derived from thiodiphenols, dihydroxynaphthalene type epoxy resins, dihydroxyanthracene type epoxy resins, dihydroxydihydroanthracene type epoxy resins, dicyclopentadiene type epoxy resins, epoxy resin derived from dihydroxystilbene, phenol novolac type epoxy resins, cresol novolac type epoxy resins, bisphenol A novolac type epoxy resins, naphthol novolac type epoxy resins, phenol aralkyl type epoxy resins, naphthol aralkyl type epoxy resins, biphenyl aralkyl type epoxy resins, terpene phenol type epoxy resins, dicyclopentadiene phenol type epoxy resins, epoxy resins derived from condensates of phenolhydroxybenzaldehyde, epoxy resins derived from condensates of phenol-crotonaldehyde, epoxy resins derived from condensates of phenol-glyoxal, epoxy resins derived from cocondensated resins of heavy oils or pitches, phenols, and formaldehydes, epoxy resins derived from diaminodiphenyl methane, epoxy resins derived from aminophenol, epoxy resins derived from xylenediamine, epoxy resins derived from aniline, epoxy resins derived from toluidine, epoxy resins derived from methyl hexahydrophthalic acid, epoxy resins derived from benzenesulfonamide, epoxy resins derived from hydroxybenzenesulfonamide, epoxy resins derived from aminobenzenesulfonamide, and epoxy resins derived from dimer acids.

These may be used singly, or in optional combination of two or more kinds thereof at an optional blending ratio.

Among the other epoxy resins, bisphenol A type epoxy resins, tetramethylbiphenol type epoxy resins, 4,4'-biphenol type epoxy resins, biphenyl aralkyl type epoxy resins, phenol aralkyl type epoxy resins, dihydroxyanthracene type epoxy resins, dicyclopentadiene type epoxy resins, orthocresol novolac type epoxy resins, and trisphenol methane type epoxy resins are particularly preferred among the above from the viewpoint of the flowability of the composition, in addition, the heat resistance, moisture absorption resistance, flame resistance, stress resistance, toughness of a cured product, and the like.

In a case in which the curable resin composition of the present embodiment includes the other epoxy resin, the content thereof is preferably 0.01 to 60 parts by weight, more preferably 40 parts by weight or less, still more preferably 30 parts by weight or less, and particularly preferably 20 parts by weight or less, and more preferably 1 part by weight or more with respect to 100 parts by weight of the total epoxy resin component in the composition.

### [Curing Accelerators]

The curable resin composition of the present embodiment preferably includes a curing accelerator. The inclusion of the curing accelerator enables a shortening of curing time, and a decrease in curing temperature, whereby a desired cured product can be easily obtained.

The curing accelerator is not particularly limited, and specific examples thereof include phosphorus-based compounds such as organic phosphines and phosphonium salts, tetraphenyl boron salts, organic acid dihydrazides, boron halide amine complexes, aromatic urea, and aliphatic urea.

Examples of the phosphorus-based compounds that can be used as such curing accelerators include: organic phosphines such as triphenylphosphine, diphenyl(p-tolyl)phosphine, tris(alkylphenyl)phosphine, tris(alkoxyphenyl)phosphine, tris(alkyl-alkoxyphenyl)phosphine, tris(dialkylphenyl)phosphine, tris(trialkylphenyl)phosphine, tris(tetraalkylphenyl)phosphine, tris(dialkoxyphenyl)phosphine, tris(trialkoxyphenyl)phosphine, tris(tetraalkyloxyphenyl)phosphine, trialkylphosphine, dialkylarylphosphine, and alkyldiarylphosphine; complexes of these organic phosphines and organic borons; and compounds obtained by adding a maleic anhydride, a quinone compound such as 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, or phenyl-1,4-benzoquinone, or a compound such as diazophenylmethane to the organic phosphines.

Among the curing accelerators, organic phosphines and phosphonium salts are preferred, and organic phosphines are most preferred. The curing accelerators may be used singly, or may be mixed and used in optional combination of two or more kinds thereof at an optional ratio.

In the case of using dicyandiamide as a curing agent, it is preferable to use aromatic urea or aliphatic urea as such a curing accelerator.

The curing accelerator is preferably used in a range of 0.1 by weight or more and 20 parts by weight or less with respect to 100 parts by weight of the total epoxy resin component in the curable resin composition. The range is more preferably 0.5 parts by weight or more, and still more preferably 1 part by weight or more, and more preferably 15 parts by weight or less, and still more preferably 10 parts by weight or less. A case in which the content of the curing accelerator is not less than the lower limit value described above is preferred because a favorable curing acceleration effect can be obtained, and a case in which the content of the curing accelerator is not more than the upper limit value described above is preferred because a desired cured product property is easily obtained.

### [Inorganic Fillers]

The curable resin composition of the present embodiment can be blended with an inorganic filler. Examples of the inorganic filler include fused silica, crystalline silica, glass powder, alumina, calcium carbonate, calcium sulfate, talc, and boron nitride. These may be used singly, or in optional combination of two or more kinds thereof at an optional blending ratio. Of these, crushed and/or spherical, fused and/or crystalline silica powder fillers are preferred in the case of use thereof in applications for sealing semiconductors.

Use of such an inorganic filler enables the thermal expansion coefficient of a semiconductor sealing material to be allowed to approach that of an internal silicon chip or lead frame, and the moisture absorption of the whole semiconductor sealing material to be reduced in the case of using a curable resin composition as the semiconductor sealing material, and therefore enables solder cracking resistance to be improved.

The average particle diameter of the inorganic filler is typically 1 to 50 µm, preferably 1.5 to 40 µm, and more preferably 2 to 30 µm. A case in which the average particle diameter is not less than the lower limit value described above is preferred because melt viscosity is prevented from being excessively increased, and flowability is inhibited from deteriorating. A case in which an average particle diameter is not more than the upper limit value described above is preferred because a narrow gap of a die is inhibited from being clogged with the filler in molding, and the filling properties of the material are easily improved.

In the case of using the inorganic filler in the curable resin composition of the present embodiment, the inorganic filler is preferably blended in a range of 60 to 95% by weight of the total epoxy resin composition.

### [Mold Release Agents]

The curable resin composition of the present embodiment can be blended with a mold release agent. As the mold release agent, for example, a natural wax such as carnauba wax, a synthetic wax such as polyethylene wax, a higher fatty acid such as stearic acid or zinc stearate, or a metallic salt thereof, or a hydrocarbon-based mold release agent such as paraffin can be used. These may be used singly, or in optional combination of two or more kinds thereof at an optional blending ratio.

In the case of blending the curable resin composition of the present embodiment with the mold release agent, the blending amount of the mold release agent is preferably 0.1 to 5.0 parts by weight, more preferably 0.5 to 3.0 parts by weight, with respect to 100 parts by weight of the total epoxy resin component in the curable resin composition. A case in which the blending amount of the mold release agent is in the range described above is preferred because favorable mold release characteristics can be exhibited while maintaining the curing characteristics of the curable resin composition.

### [Coupling Agents]

The curable resin composition of the present embodiment is preferably blended with a coupling agent. The coupling agent is preferably used together with an inorganic filler, and the blending of the coupling agent enables improvement in adhesiveness between the inorganic filler and an epoxy resin which is a matrix. Examples of the coupling agent include silane coupling agents and titanate coupling agents.

Examples of the silane coupling agents include: epoxysilanes such as γ-glycidoxypropyltrimethoxysilane, γ-glycidoxypropyltriethoxysilane, and β-(3,4-epoxycyclohexyl)ethyltrimethoxysilane; aminosilanes such as γ-aminopropyltriethoxysilane, N-β(aminoethyl)γ-aminopropyltrimethoxysilane, N-β(aminoethyl)γ-aminopropylmethyldimethoxysilane, γ-aminopropyltrimethoxysilane, and γ-ureidopropyltriethoxysilane; mercaptosilanes such as 3-mercaptopropyltrimethoxysilane; vinylsilanes such as p-styryltrimethoxysilane, vinyltrichlorosilane, vinyltris(β-methoxyethoxy)silane, vinyltrimethoxysilane, vinyltriethoxysilane, and γ-methacryloxypropyltrimethoxysilane; and epoxy-based, amino-based, or vinyl-based polymer-type silanes.

Examples of the titanate coupling agents include isopropyl triisostearoyltitanate, isopropyl tri(N-aminoethyl-aminoethyl)titanate, diisopropyl bis(dioctylphosphate)titanate, tetraisopropyl bis(dioctylphosphite)titanate, tetraoctyl bis(ditridecylphosphite)titanate, tetra(2,2-diallyloxymethyl-1-butyl)bis(ditridecyl)phosphitetitanate, bis(dioctylpyrophosphate)oxyacetatetitanate, and bis(dioctylpyrophosphate)ethylenetitanate.

The coupling agents may be used singly, or may be mixed and used in optional combination of two or more kinds thereof at an optional ratio.

In the case of using the coupling agent in the curable resin composition of the present embodiment, the blending amount thereof is preferably 0.1 to 3.0 parts by weight with respect to 100 parts by weight of the total epoxy resin component. A case in which the blending amount of the coupling agent is not less than the lower limit value described above is preferred because the effect of improving adhesiveness between the inorganic filler and the epoxy resin which is a matrix due to the blending of the coupling agent tends to be improved. A case in which the blending amount of the coupling agent is not more than the upper limit value described above is preferred because the coupling agent is inhibited from bleeding from an obtained cured product.

### [Toughness-Imparting Materials]

The curable resin composition of the present embodiment can be blended with a toughness-imparting material. Examples of the toughness-imparting material include thermoplastic resins and core-shell-type elastomers. Especially, such a thermoplastic resin is preferred because viscoelasticity can be controlled. Examples of the thermoplastic resin include, but are not limited to, polyamide, polyester, polycarbonate, polyethersulfone, polyphenylene ether, polyphenylene sulfide, polyether ether ketone, polyether ketone, polyetherimide, polyimide, polytetrafluoroethylene, polyether, polyolefin, liquid crystal polymer, polyarylate, polysulfone, polyacrylonitrile-styrene, polystyrene, polyacrylonitrile, polymethyl methacrylate, acrylonitrile-butadiene-styrene copolymer (ABS resin), acrylonitrile-ethylene-propylene-diene-styrene copolymer (AES resin), acrylonitrile-styrene-alkyl (meth)acrylate copolymer (ASA resin), polyvinyl chloride, polyvinyl formal, phenoxy resin, and block polymers. These thermoplastic resins may be used singly, or in combination of two or more kinds thereof.

In a case in which the curable resin composition of the present embodiment includes the thermoplastic resin, the blending amount of the thermoplastic resin in the curable resin composition is preferably 0.2 to 45 parts by weight, more preferably 0.5 to 25 parts by weight, with respect to 100 parts by weight of the total epoxy resin component. A case in which the content of the thermoplastic resin is 0.2 parts by weight or more is preferred because the effect of improving the toughness of a cured product can be sufficiently exerted. A case in which the content of the thermoplastic resin is 45 parts by weight or less is preferred because a prepreg or towpreg having an appropriate tack is obtained, and an epoxy resin composition having the suitable temperature dependence of viscosity is obtained. The range of the blending amount described above can also be adopted as the blending amount of a toughness-imparting material other than the thermoplastic resins.

### [Reinforced Fibers]

The curable resin composition of the present embodiment can be blended with reinforced fibers. Examples of the materials of the reinforced fibers include glass fibers, carbon fibers, aramid fibers, and boron fibers. Carbon fibers are preferred as the reinforced fibers from the viewpoint of the mechanical properties and weight reduction of an obtained fiber reinforced plastic. The number of carbon fibers in a carbon fiber bundle used in a reinforced fiber base material is preferably 1,000 to 70,000. A sheet-shaped reinforced fiber base material in which a plurality of carbon fiber bundles are used, and fibers are aligned in one direction can be made.

It is preferable that the reinforced fibers exist as a reinforced fiber base material (an aggregate of the reinforced fibers) in a prepreg, and have a sheet shape. The reinforced fibers may be unidirectionally arranged, or arranged in random directions. Examples of the forms of the reinforced fibers include woven articles of reinforced fibers, nonwoven fabrics of reinforced fibers, and sheets in which the long fibers of reinforced fibers are aligned in one direction. From the viewpoint of enabling molding of a fiber reinforced plastic having a high specific tensile strength and specific modulus, the reinforced fibers preferably form a sheet including bundles of the reinforced fibers in which long fibers are unidirectionally aligned. The reinforced fibers preferably form a woven article of the reinforced fibers from the viewpoint of easy handling of the woven article.

From the viewpoint of the rigidity of the obtained fiber reinforced plastic, the strand tensile strength of the carbon fibers is preferably 1.5 to 9 GPa, and the strand tensile elasticity of the carbon fibers is 150 to 260 GPa. The strand tensile strength and strand tensile elasticity of the carbon fibers can be measured according to JIS R760 1: 1986.

### [Method of Producing Prepreg]

The prepreg is obtained by impregnating the reinforced fiber base material with the epoxy resin composition of the present embodiment. In the prepreg obtained in such a manner, the reinforced fiber base material is impregnated with the epoxy resin composition. Examples of a method of impregnating the reinforced fiber base material with the epoxy resin composition include, but are not limited to: a wet method in which an epoxy resin composition is dissolved in a solvent such as methyl ethyl ketone or methanol to have a decreased viscosity, and an aggregate of reinforced fibers is then impregnated with the epoxy resin composition; and a hot melt method (dry-method) in which the viscosity of an epoxy resin composition is decreased by heating, and an aggregate of reinforced fibers is then impregnated with the epoxy resin composition.

### [Fiber Reinforced Plastic]

It is preferable that the fiber reinforced plastic is a cured product of the prepregs described above, and the cured product is a cured product of a laminate in which the two or more prepregs are laminated. The fiber reinforced plastic may be obtained by curing part of the prepregs. In other words, the fiber reinforced plastic includes: the cured product of the epoxy resin composition included in the prepregs; and the reinforced fibers. The fiber reinforced plastic is obtained by molding by, for example, a method in which the two or more prepregs described above are laminated, followed by heat-curing the epoxy resin composition while applying a pressure to the obtained laminate.

Examples of such molding methods include a press molding method, an autoclave molding method, a bagging molding method, a wrapping tape method, an internal pressure molding method, and a sheet wrap molding method, as well as RTM (resin transfer molding), VaRTM (vacuum assisted resin transfer molding: vacuum resin impregnation production method), filament winding, and RFI (resin film infusion), in which a molded product is obtained by impregnating the filaments or preforms of reinforced fibers with an epoxy resin composition, and curing the resultant, but are not limited to these molding methods.

Curing conditions for obtaining a cured product described later can be applied to conditions for curing the epoxy resin composition for molding.

### [Other Blending Components]

The curable resin composition of the present embodiment can be blended with a component other than the above (which may be referred to as "other blending component" in the present disclosure). Examples of such other blending components include flame retardants, plasticizers, reactive diluents, and pigments, which can be optionally blended as appropriate. However, the curable resin composition of the present embodiment may be blended with a component other than the components mentioned above.

Examples of such a flame retardant used in the curable resin composition of the present embodiment include: halogen-based flame retardants such as brominated epoxy resins and brominated phenol resins; antimony compounds such as antimony trioxide; phosphorus-based flame retardants such as red phosphorus, phosphate esters, and phosphines; nitrogen-based flame retardants such as melamine derivatives; and inorganic flame retardants such as aluminum hydroxide and magnesium hydroxide.

### [Confirmation of Blending Component]

Blending of the curable resin composition according to the present embodiment with the epoxy resin according to the first embodiment of the present invention, another blending component, or the like can be confirmed by subjecting the curable resin composition to separation and purification, and then to qualitative analysis and/or quantitative analysis by a nuclear magnetic resonance apparatus, a mass spectroscope, and/or a chromatograph.

### [Cured Product]

A cured product can be obtained by curing the curable resin composition according to the present embodiment. The term "curing" as used herein means that an epoxy resin is intentionally cured by, for example, heat and/or light. The degree of the curing may be controlled by desired physical properties, applications, and the like.

A curing method in the case of curing the curable resin composition according to the present embodiment to make the cured product depends on, for example, a blending component, a blending amount, or the form of a blend in the curable resin composition, and typical examples thereof include heating conditions of 50 to 200°C and 5 seconds to 180 minutes. This heating is preferably performed in two-step treatment of primary heating at 50 to 160°C for 5 seconds to 30 minutes and secondary heating at 90 to 200°C, higher than the primary heating temperature by 40 to 120°C, for 1 minute to 150 minutes in view of reducing poor curing.

In production of the cured product as a semi-cured product, the reaction of curing the curable resin composition may be allowed to proceed so that the form thereof can be kept by heating or the like. In a case in which the curable resin composition includes a solvent, most of the solvent can be removed by a technique such as heating, decompression, or air-drying, and 5% by weight or less of the solvent may be allowed to remain in the semi-cured product.

The inclusion of the epoxy resin according to the first embodiment of the present invention in the cured product can be confirmed by decomposing the cured product by a suitable method, and then analyzing the cured product by a suitable analysis method such as nuclear magnetic resonance spectrometry (NMR), infrared spectroscopy, or various types of chromatography, to specify the epoxy resin according to the first embodiment of the present invention from the cured product.

The lower limit value of the glass transformation temperature of the cured product is preferably 150°C or more, more preferably 190°C or more, and particularly preferably 200°C or more. In a case in which the glass transformation temperature of the cured product is not more than the lower limit value described above, the elastic modulus of the cured product may be decreased at a practical operating temperature. On the other hand, the upper limit of the glass transformation temperature is preferably 450°C or less, and more preferably 400°C or less. In the case of producing a cured product of which the glass transformation temperature is not less than the upper limit value described above, a curing temperature and the composition of the cured product may be unmatched with a common current process.

The glass transformation temperature of the cured product can be measured by a known method. For example, the glass transformation temperature can be measured by a method described in Examples described later.

The lower limit value of the storage elastic modulus of the cured product is preferably more than 3.0 GPa, more preferably more than 3.7 GPa, and particularly preferably more than 4.0 GPa. In a case in which the storage elastic modulus is not less than the lower limit value described above, rigidity capable of enduring practical use can be secured. The upper limit value of the storage elastic modulus is preferably 10 GPa or less, more preferably 8 GPa or less, and particularly preferably 5 GPa or less. In the case of producing a cured product of which the storage elastic modulus is not less than the upper limit value described above, a curing temperature and the composition of the cured product may be unmatched with a common current process.

The storage elastic modulus of the cured product can be measured by a known method. For example, the storage elastic modulus can be measured by a method described in Examples described later.

The lower limit value of the bending elastic modulus of the cured product is preferably 3.0 GPa or more, more preferably 3.5 GPa or more, still more preferably 3.8 GPa or more, and particularly preferably more than 4.0 GPa. In a case in which the bending elastic modulus is not less than the lower limit value described above, rigidity capable of enduring practical use can be secured. The upper limit value of the bending elastic modulus is preferably 10 GPa or less, more preferably 8 GPa or less, and particularly preferably 5 GPa or less. In the case of producing a cured product of which the bending elastic modulus is not less than the upper limit value, a curing temperature and the composition of the cured product may be unmatched with a common current process.

The bending strength of the cured product can be measured by a known method. For example, the bending strength can be measured by a method described in Examples described later.

The lower limit value of the bending strength of the cured product is preferably 100 MPa or more, more preferably 150 MPa or more, still more preferably 160 MPa or more, and particularly preferably 180 MPa or more. In a case in which the bending strength is not less than the lower limit value described above, strength capable of enduring practical use can be secured. The upper limit value of the bending elastic modulus is preferably 5,000 MPa or less, more preferably 1,000 MPa or less, and particularly preferably 500 MPa or less. In the case of producing a cured product of which the bending elastic modulus is not less than the upper limit value, a curing temperature and the composition of the cured product may be unmatched with a common current process.

The lower limit value of the yield elongation of the cured product is preferably 1% or more, more preferably 3% or more, still more preferably 5% or more, and particularly preferably 7% or more. In a case in which the yield elongation is not less than the lower limit value described above, rigidity capable of enduring practical use can be secured. The upper limit value of the yield elongation is preferably 40% or less, more preferably 30% or less, and particularly preferably 20% or less. In the case of producing a cured product of which the yield elongation is not less than the upper limit value, a curing temperature and the composition of the cured product may be unmatched with a common current process.

The yield elongation of the cured product can be measured by a known method. For example, the yield elongation can be measured by a method described in Examples described later.

### [Applications]

The first embodiment of the present invention relates to an epoxy resin that is excellent in miscibility with another epoxy resin and a curing agent, and provides a cured product having favorable heat resistance and a favorable elastic modulus. A second embodiment of the present invention relates to a curable resin composition including the epoxy resin, a cured product thereof, and the like.

The epoxy resin, curable resin composition, and cured product according to the embodiments of the present invention are excellent in miscibility, heat resistance, and an elastic modulus, and the like, and can be therefore used mainly in many applications such as paint, civil engineering, and electric fields. The epoxy resin according to the present embodiment (modified glycidyl amine type epoxy resin) can be preferably used, especially in: a paint (composition); a binder for an adhesive agent; a base material for a prepreg; a base material for a laminate; a semiconductor sealing agent; a coating film; a base material for a fiber reinforced plastic (FRP); an electric and electronic material; or the like. Specifically, the epoxy resin resin composition according to the present embodiment can be preferably used in a paint, an adhesive agent, a prepreg, a laminate, a semiconductor sealing material, or the like, and the cured product of the resin composition is preferably included in a coating film, a bonded body, a fiber reinforced plastic (FRP), a semiconductor sealing agent, an electric and electronic material, or the like.

### EXAMPLES

The present invention is more specifically described below with reference to Examples. However, the present invention is not limited at all to the following Examples. The values of various production conditions and evaluation results in the following Examples have meanings as the preferred values of upper or lower limits in aspects of the present invention, and preferred ranges may be ranges defined by the values of the upper or lower limits and the values in the following Examples or combinations of the values in Examples.

### [Raw Materials Used]

In the following Examples and Comparative Examples, the following substances were used as raw materials.

### [Amine Compound]

The following compound was used as an amine compound.

### m-Tolidine (4,4'-diamino-2,2'-dimethylbiphenyl, m-TB-HG manufactured by Seika Corporation)

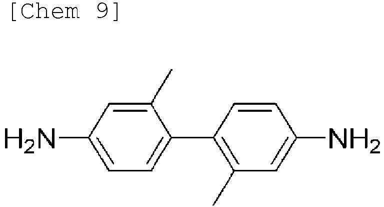

### [Epoxy Resin (A)]

The following A-1 and A-2 were used as epoxy resins (A).
A-1: Bisphenol A type epoxy resin (jER (registered trademark) 828 manufactured by Mitsubishi Chemical Corporation, epoxy equivalent: 185 g/eq) 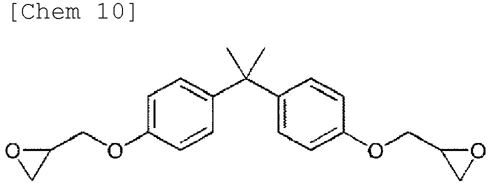
A-2: Phenol novolac type liquid epoxy resin (jER (registered trademark) 152 manufactured by Mitsubishi Chemical Corporation, epoxy equivalent: 175 g/eq)

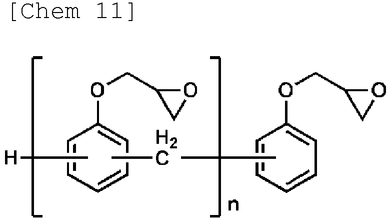

### [Curing Agent (B)]

The following B-1 and B-2 were used as curing agents (B).
B-1: m-Tolidine (4,4'-diamino-2,2'-dimethylbiphenyl, m-TB-HG manufactured by Seika Corporation) 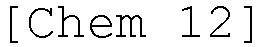 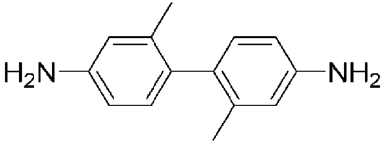
B-2: Dicyandiamide (DICY, jERCURE (registered trademark) DICY7 manufactured by Mitsubishi Chemical Corporation)

### [Curing Accelerator (C)]

The following C-1 was used as a curing accelerator (C).
C-1: 3-(3,4-Dichlorophenyl)-1,1-dimethylurea (DCMU, Tokyo Chemical Industry Co., Ltd.)

### [Production and Evaluation of This Epoxy Resin]

### [Production of This Epoxy Resin]

### {Example 1}

In a separable flask provided with a Dimroth condenser, a nitrogen introduction pipe, and a thermocouple, m-tolidine (250 g, 1.18 mol), epichlorohydrin (1199 g, 12.95 mol), isopropyl alcohol (584 g), and water (910 g) were put, and the temperature thereof was increased to 30°C. Then, the steps A to D described above were carried out under ordinary pressure at temperatures and times set forth in Table 1. In the step C, a 48% aqueous sodium hydroxide solution (466 g) was dripped at a constant rate. An organic phase was washed with water, and then concentrated to obtain a crude objective substance. The crude objective substance was redissolved in methyl isobutyl ketone (514 g), a 48% aqueous sodium hydroxide solution (14 g) was added to the solution, and the resultant was stirred at 60°C for 1 hour, subjected to the reaction of the ring closure of a 1,2-chlorhydrine body to increase the purity thereof. The organic phase was washed until an aqueous phase became neutral. Then, the organic phase was concentrated to obtain an epoxy resin.

### {Example 2}

In a separable flask provided with a Dimroth condenser, a nitrogen introduction pipe, and a thermocouple, m-tolidine (80 g, 0.377 mol), epichlorohydrin (384 g, 4.15 mol), isopropyl alcohol (187 g), and water (291 g) were put, and the temperature thereof was increased to 30°C. Then, the steps A to D were carried out under ordinary pressure at temperatures and times set forth in Table 1. In the step C, a 48% aqueous sodium hydroxide solution (149 g) was dripped at a constant rate. An organic phase was washed with water, and then concentrated to obtain an epoxy resin.

### {Comparative Example 1}

In a separable flask provided with a Dimroth condenser, a nitrogen introduction pipe, and a thermocouple, m-tolidine (80 g, 0.377 mol), epichlorohydrin (279 g, 3.01 mol), isopropyl alcohol (136 g), and water (212 g) were put, and the temperature thereof was increased to 30°C. Then, the steps A to D were carried out under ordinary pressure at temperatures and times set forth in Table 1. In the step C, a 48% aqueous sodium hydroxide solution (149 g) was dripped at a constant rate. An organic phase was washed with water, and then concentrated to obtain an epoxy resin.

### [Evaluation of Modified Glycidyl Amine Type Epoxy Resin]

The epoxy equivalents, viscosities, chlorinities, and amounts of oligomer components in the obtained modified glycidyl amine type epoxy resins were measured by the following method, and set forth in Table 1.

### <Epoxy Equivalent>

The epoxy equivalent in such an epoxy resin was measured by potentiometric titration using a method of correcting glycidyl amine on the basis of JIS K 7236. Specifically, dripping of a 0.1 mol/L solution of perchloric acid and acetic acid into a solution of the modified glycidyl amine type epoxy resin in chloroform caused a salt of amine and perchloric acid to be generated to obtain a titer V2 at the titration end-point. Then, tetraethylammonium bromide was further added into the system, the dripping of a 0.1 mol/L solution of perchloric acid and acetic acid was continued, and the epoxy equivalent was calculated based on a value obtained by subtracting the titer V2 from a titer V1 at the titration end-point.

### <Viscosity at 50°C>

The viscosity of the epoxy resin at 50°C was measured by a rheometer (HAAKE MARS40, manufactured by Thermo Fisher Scientific). The conditions of the measurement were set at an oscillation mode, a frequency of 1 Hz, and 50°C. Such a viscosity at 50°C herein is a viscosity in a case in which a liquid or a crystalline compound exists in a supercooled liquid state.

### <Viscosity at 150°C >

The viscosity of the epoxy resin at 150°C was measured by an ICI viscometer (cone-plate viscometer CV-1, manufactured by Toa Kogyo Co., Ltd.). The condition of the measurement was set at 150°C.

### <Amount of Easily Saponifiable Chlorine>

The amount of easily saponifiable chlorine in the epoxy resin was demanded according to JIS K7243-2. The amounts of easily saponifiable chlorine in the epoxy resins, set forth in Table 1, are amounts based on mass.

### <Total Amount of Chlorine>

The total amount of chlorine in the epoxy resin was determined by a technique of detecting the amount of chlorine, equivalent to a method of determination according to JIS K7243-3. In other words, the total amount was measured by the following procedure. In a beaker, 0.05 to 0.2 g of sample was accurately weighed, followed by adding 25 mL of a mixed solution of toluene and dimethyl cellosolve methyl cellosolve. Nitrogen bubbling was performed while performing stirring. Addition of 5 to 10 mL of biphenyl sodium was performed, and the resultant was left unattended for 3 to 5 minutes. The nitrogen bubbling was stopped, and 1 mL of 6% hydrogen peroxide was added. Addition of 20 mL acetic acid was performed, followed by performing potentiometric titration with a 1/100 N silver nitrate solution. The total amounts of chlorine in the epoxy resins, set forth in Table 1, are amounts based on mass.

In Examples herein, the epoxy resin used in each of Examples and Comparative Examples hardly included a halogen other than chlorine (less than ppm order even if including such a halogen). The amount of easily saponifiable chlorine and the total amount of chlorine can be substantially regarded as the amount of an easily saponifiable halogen and the total amount of a halogen.

### <Amount of Oligomer Component>

As described above, an oligomer component (also simply referred to as "oligomer") including a compound X herein refers to a compound group of which the retention time is longer than the retention time of the compound X in reverse phase HPLC measurement. The content rate of the oligomer component is calculated based on the following equation from a peak area derived from the oligomer component and the total area of the detected peak in reverse phase HPLC measurement using a UV detector at 280 nm. Content rate (% by area) of oligomer component = (peak area derived from oligomer component/total area of detected peak) × 100

The conditions of the measurement are as follows.
Pump: Binary RHPLC Semi-micro pump, PU-4185-Binary, manufactured by JASCO Corporation
Detector: PDA detector, MD-41010, manufactured by JASCO Corporation
Column: Unifinepak C18 03150-3M (column size of 3.0 mm φ ×150 mm, particle diameter of 3 µm)
Flow rate: 0.7 mL/min
Column temperature: 40°C
Sample amount: 0.1 g of sample/10 mL of THF, injection of 0.5 µL
Gradient conditions: H₂O/acetonitrile = 60/40 → 0/100 (0 to 25 min) → 0/100 (25 to 30 min)

### <Content Rate of Compound X>

The content rate of the compound X is calculated based on the following equation from a peak area derived from the compound X and the total area of the detected peak in reverse phase HPLC measurement using a UV detector at 280 nm. Content rate (% by area) of compound X = (peak area derived from compound X/total area of detected peak) × 100

The retention time of the compound X by the reverse phase HPLC measurement under the following measurement conditions is around 9.6 min.

The measurement conditions are as follows.
Pump: Binary RHPLC Semi-micro pump, PU-4185-Binary, manufactured by JASCO Corporation
Detector: PDA detector, MD-41010, manufactured by JASCO Corporation
Column: Unifinepak C18 03150-3M (column size of 3.0 mm φ ×150 mm, particle diameter of 3 µm)
Flow rate: 0.7 mL/min
Column temperature: 40°C
Sample amount: 0.1 g of sample/10 mL of THF, injection of 0.5 µL
Gradient conditions: H₂O/acetonitrile = 60/40 → 0/100 (0 to 25 min) → 0/100 (25 to 30 min)

### <Evaluation>

An evaluation was performed according to the quality of the obtained epoxy resin. An evaluation of B or greater was regarded as a practical use level because of exhibiting favorable handleability.
A: A viscosity at 50°C is less than 300,000 mPa·s, and the total amount of chlorine is less than 10,000 ppm.
B: A viscosity at 50°C is less than 300,000 mPa·s, and the total amount of chlorine is 10,000 ppm or more.
C: A viscosity at 50°C is 300,000 mPa·s or more.

**[Table 1]**

| | | | Example 1 | Example 2 | Comparative Example 1 |
|---|---|---|---|---|---|
| Production method | ECH / substrate | mol/mol | 11.0 | 11.0 | 8.0 |
| | Step A | | 30→65°C, 90min | 30→65°C, 60min | 30→65°C, 30min |
| | Step B | | 65°C, 90min | 65°C, 30min | 65°C, 30min |
| | Step C | | 65°C, 120min | 65°C, 90min | 65°C, 90min |
| | Step D | | 65°C, 60min | 65°C, 60min | 65°C, 30min |
| Quality | Epoxy equivalent | g/eq | 115 | 131 | 127 |
| | Viscosity at 50 °C | mPa·s | 90000 | 131000 | 530000 |
| | Viscosity at 150 °C | mPa·s | 50 | 79 | 105 |
| | Amount of easily saponifiable chlorine | ppm | 136 | 10133 | 3154 |
| | Total amount of chlorine | ppm | 5003 | 14888 | 7373 |
| | Amount of oligomer component | % by area | 57 | 16.5 | 19.6 |
| | Content of compound X | % by area | 88.0 | 63.5 | 62.5 |
| Evaluation | | | A | B | C |

### [Production and Evaluation of Curable Resin Composition and Cured Product]

### {Examples 3 to 4, and Comparative Examples 2 to 6}

In Examples 3 to 4 and Comparative Examples 2 to 6, the epoxy resins produced in Examples 1 to 2 and Comparative Example 1, and the epoxy resins A-1 and A-2 described above were used as set forth in Tables 2 to 3. In a curing system 1, m-tolidine (B-1) was used as a curing agent. In a curing system 2, dicyandiamide (DICY) was used as a curing agent, and 3-(3,4-dichlorophenyl)-1,1-dimethylurea (DCMU) was used as a curing accelerator. DICY and DCMU, each of which was previously dispersed in the epoxy resin A-1 by using a three-roll mill, were used.

Resin compositions according to Examples 3 to 4 and Comparative Examples 2 to 6 were blended according to blending ratios in Tables 2 to 3, produced, and subjected to evaluation of the miscibility thereof. In a case in which the miscibility was evaluated as B, subsequent evaluation was not carried out.

Then, in the curing system 1, the resultant was preheated at 120°C for 2 hours, heated at 175°C for 6 hours, and cured to produce a cured product plate having a thickness of 3 mm. In the curing system 2, the resultant was preheated at 80°C for 1 hour, heated at 130°C for 1.5 hours, and cured to produce a cured product plate having a thickness of 3 mm. The produced cured products were subjected to dynamic viscoelastic measurement (DMS) and a bending test, and the heat resistances and elastic moduli of the cured products were comprehensively determined and set forth in Tables 2 to 3.

The used amount of each material set forth in Tables 2 to 3 is an amount in terms of a solid content.

### <Miscibility>

Whether or not each component was easily homogeneously mixed in the blending was evaluated as follows, and the result thereof was regarded as an index of the miscibility.

### <<Evaluation Criteria>>

A: A blend was weighed on an aluminum dish so that the total weight of the blend was 10 g. The blend was able to be homogeneously mixed within five minutes on a hot plate, warmed to 120°C, by using a metallic spatula.
B: A blend was weighed on an aluminum dish so that the total weight of the blend was 10 g. The blend was mixed for five minutes on a hot plate, warmed to 120°C, by using a metallic spatula. However, the viscosity of an epoxy resin used is considerably high, and it was difficult to homogeneously mix the blend.

### <Heat Resistance>

The temperatures were increased to 30 to 300°C at 5°C/min, and the heat resistances in Examples and Comparative Examples were measured by using a dynamic viscoelasticity measurement apparatus "DMS6100" manufactured by Seiko Instruments Inc. A deformation mode was set at doubly supported beam bending, and a measurement frequency was set at 1 Hz. A glass transformation temperature (Tg) was set at a temperature at which a loss tangent tan δ (= loss modulus E''/storage elastic modulus E') shows the local maximum point. The glass transformation temperature was regarded as an index of heat resistance. The higher glass transformation temperature means better heat resistance.

### <Elastic Modulus>

The temperatures were increased to 30 to 300°C at 5°C/min, and the elastic moduli in Examples and Comparative Examples were measured by using a dynamic viscoelasticity measurement apparatus "DMS6100" manufactured by Seiko Instruments Inc. A deformation mode was set at doubly supported beam bending, and a measurement frequency was set at 1 Hz. For such an elastic modulus, a storage elastic modulus E' at a measurement temperature of 40°C was regarded as an index of the elastic modulus in the curing system 1, and a storage elastic modulus E' at a measurement temperature of 50°C was regarded as an index of the elastic modulus in the curing system 2.

For such an elastic modulus at a high temperature, a storage elastic modulus E' at a measurement temperature of 250°C was regarded as an index of a high-temperature elastic modulus in the curing system 1, and a storage elastic modulus E' at a measurement temperature of 180°C was regarded as an index of a high-temperature elastic modulus in the curing system 2.

### <Mechanical Properties>

In Example 4 and Comparative Examples 4 to 6, mechanical properties were measured by a bending test. In the bending test, a universal testing machine "INSTRON5582" manufactured by Instron was used, the size of a test piece was set at 80 × 10 × 3 mm, a supporting-point distance was set at 48 mm, a test temperature was set at 23°C, and the measurement was performed by a method according to JIS K7171. A bending elastic modulus, a bending strength, a yield elongation, and a rupture elongation were analyzed based on an SS curve obtained in the measurement, and were regarded as indices of the mechanical properties.

### <Comprehensive Evaluation>

A comprehensive evaluation was performed based on the test results of the miscibility, the heat resistance, and the elastic modulus. An evaluation of A or greater was regarded as a practical use level.

### <<Evaluation Criteria>>

A: Miscibility is evaluated as A, a glass transformation temperature is 200°C or more, and a storage elastic modulus E' at 40 to 50°C is 4.0 GPa or more.
B: Miscibility is evaluated as A, a glass transformation temperature is less than 200°C, and a storage elastic modulus E' at 40 to 50°C is less than 4.0 GPa.
C: Miscibility is evaluated as B.

**[Table 2]**

| Curing system 1 | | | Example 3 | Comparative Example 2. | Comparative Example 3 |
|---|---|---|---|---|---|
| Epoxy resin | Kind | | Example 1 | Comparative Example 1 | A-1 |
| | Blending amount [parts by weight] | | 100 | 100 | 100 |
| Curing agent | Kind | | B-1 | B-1 | B-1 |
| | Blending amount [parts by weight] | | 45 | 45 | 29 |
| Miscibility | | | A | B | A |
| Curing conditions | | | 120°C, 2hr → 175°C, 6hr | | |
| DMS | E' (40°C) | GPa | 4.2 | - | 2.4 |
| | E' (250°C) | MPa | 1323.7 | - | 42.8 |
| | tanδ (Tg) | °C | 287.2 | - | 189.5 |
| Evaluation | | | A | C | B |

**[Table 3]**

| Curing system 2 | | | | Example 4 | Comparative Example 4 | Comparative Example 5 | Comparative Example 6 |
|---|---|---|---|---|---|---|---|
| Epoxy resin 1 | | Kind | | Example 1 | Comparative Example 1 | A-2 | A-1 |
| | | Blending amount [parts by weight] | | 50 | 50 | 50 | 100 |
| Epoxy resin 2 | | Kind | | A-1 | A-1 | A-1 | - |
| | | Blending amount [parts by weight] | | 50 | 50 | 50 | - |
| Curing agent (DICY) | | Blending amount [parts by weight] | | 6.7 | 6.7 | 5.4 | 5.2 |
| Curing accelerator (DCMU) | | Blending amount [parts by weight] | | 3.9 | 3.9 | 3.1 | 3.0 |
| Miscibility | | | | A | B | A | A |
| Curing conditions | | | | 80°C 1hr→130°C 1.56hr | | | |
| DMS | E' (50°C) | | GPa | 4.3 | - | 3.7 | 3.5 |
| | E' (180°C) | | MPa | 44 | - | 35 | 29 |
| | tanδ (Tg) | | °C | 208 | - | 143 | 147 |
| Bending | Bending elastic modulus | | Gpa | 4.0 | - | 3.4 | 3.2 |
| | Bending strength | | MPa | 192 | - | 157 | 150 |
| | Yield elongation | | % | 7.2 | - | 7.5 | 7.2 |
| | Rupture elongation | | % | 7.2 | - | 9.0 | 8.1 |
| Evaluation | | | | A | C | B | B |

### [Evaluation Results]

As can be seen from the present examples and comparative examples, it was found that an epoxy resin which has a diaminobiphenyl framework, and in which the content of an oligomer in the epoxy resin is 0.01 to 19.0% by area with respect to the total area of a detected peak in reverse phase HPLC measurement using a 280 nm UV detector has favorable miscibility with another epoxy resin and a curing agent, achieves both heat resistance and an elastic modulus, and exhibits excellent abilities.

## Claims

1. An epoxy resin comprising a compound X represented by the following Formula (1), wherein
a content rate of an oligomer comprising the compound X is 0.01 to 19.0% by area in a case in which a total area of a detected peak is 100% by area in reverse phase HPLC measurement using a 280 nm UV detector 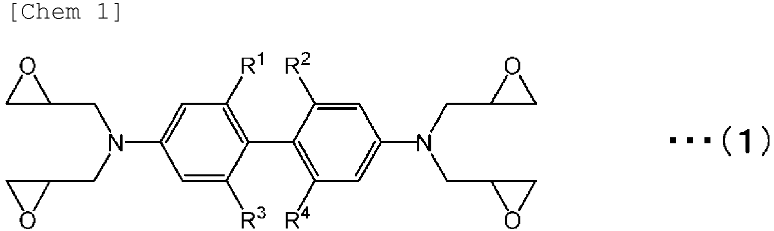 in Formula (1), R¹ to R⁴ may be same as or different from each other, are hydrogen atoms or hydrocarbon groups, or may comprise a hetero atom; R¹ to R⁴ may be bound to each other to form a ring; or at least one of R¹ to R⁴ is a hydrocarbon group.

2. The epoxy resin according to claim 1, wherein the Formula (1) is the following Formula (2): 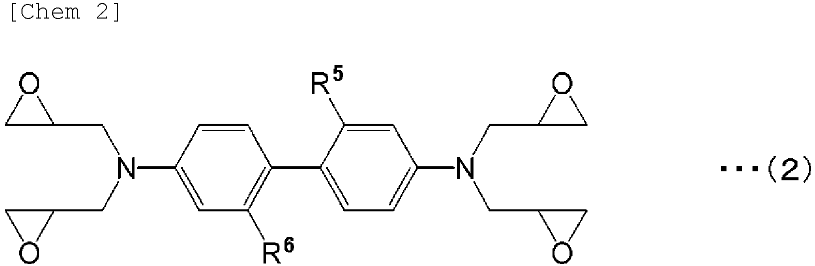 in Formula (2), R⁵ and R⁶ may be same as or different from each other, are hydrocarbon groups, or may comprise a hetero atom; or R⁵ and R⁶ may be bound to each other to form a ring.

3. The epoxy resin according to claim 2, wherein the Formula (1) is the following Formula (3).

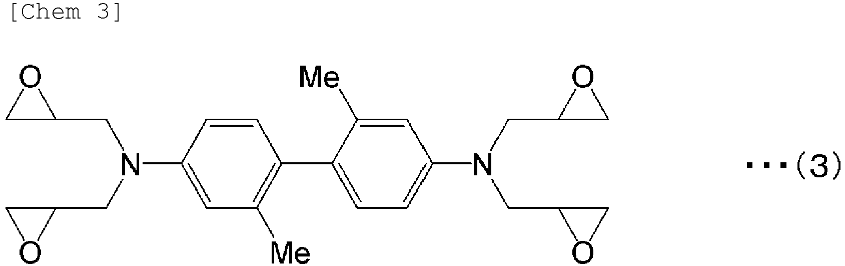

4. The epoxy resin according to any one of claims 1 to 3, wherein the epoxy resin has a viscosity of 500 to 500,000 mPa·s at 50°C.

5. The epoxy resin according to any one of claims 1 to 4, wherein the epoxy resin has an epoxy equivalent of 100 to 500 g/eq.

6. The epoxy resin according to any one of claims 1 to 5, wherein an amount of an easily saponifiable halogen is 1 to 20,000 ppm by mass.

7. A resin composition comprising: the epoxy resin according to any one of claims 1 to 6; and a curing agent.

8. A paint comprising the resin composition according to claim 7.

9. An adhesive agent comprising the resin composition according to claim 7.

10. A prepreg comprising the resin composition according to claim 7.

11. A semiconductor sealing material comprising the resin composition according to claim 7.

12. A cured product comprising the resin composition according to claim 7.

13. The cured product according to claim 12, wherein the cured product has a bending elastic modulus of 3.5 GPa or more.

14. A coating film comprising the cured product according to claim 12.

15. A bonded body comprising the cured product according to claim 12.

16. A fiber reinforced plastic comprising the cured product according to claim 12.

17. A semiconductor sealing material comprising the cured product according to claim 12.

18. An electric and electronic material comprising the cured product according to claim 12.

19. A method of producing an epoxy resin, wherein
the method comprises a step of performing a reaction between an epihalohydrin and an amine compound represented by the following Formula (4), and the epoxy resin is the epoxy resin according to any one of claims 1 to 6 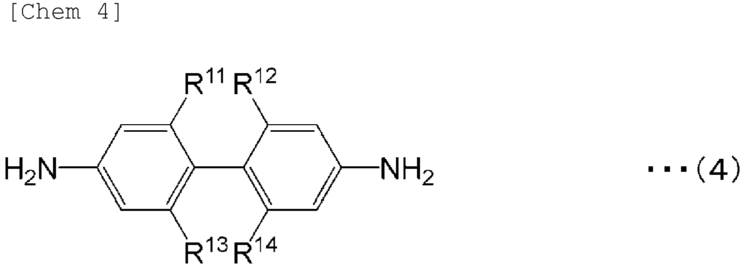 in Formula (4), R¹¹ to R¹⁴ are synonymous with R¹ to R⁴ in Formula (1), respectively.

20. The method of producing an epoxy resin according to claim 19, wherein an amount of the epihalohydrin used is 8.1 equivalents or more with respect to that of the amine compound.

21. The method of producing an epoxy resin according to claim 19 or 20, wherein in the step of performing the reaction between the amine compound and the epihalohydrin, the reaction is performed without using a catalyst, and a reaction time is more than 180 minutes.
